# EUROPEAN PATENT APPLICATION

(11) **EP 3 648 085 A1**
(43) Date of publication of application: **06.05.2020**
(21) Application number: 18825219.1
(22) Date of filing: 06.06.2018
(51) Int. Cl.: G09F 9/46, G02F 1/13, G02F 1/133, G09F 9/30

(54) **ELECTRONIC DEVICE**

(30) Priority: 27.06.2017 JP 2017125082
(71) Applicant: Toppan Printing Co., Ltd., Taito-ku, Tokyo 110-0016 (JP)
(72) Inventor: IGARASHI, Akira, Tokyo 110-0016 (JP)
(74) Representative: TBK
(86) International application number: PCT/JP2018/021726
(87) International publication number: WO 2019/003839

(57) **Abstract**

An electronic device 1 includes: a first display panel 11; a second display panel 12; a spacer 22 configured to keep a distance between the first display panel 11 and the second display panel 12; and an air layer 21 surrounded by the spacer 22. The first display panel includes: a plurality of pixel electrodes 35 which are provided on a substrate 30 and reflect light; a plurality of light-emission layers 36 which are provided on the pixel electrodes 35 and emit light; and a common electrode 37 provided on a substrate 31. The second display panel includes: a polymer dispersed liquid crystal layer 42 filled between a substrate 40 and a substrate 41; a plurality of display electrodes 43 provided on the substrate 40; and a common electrode 44 provided on the substrate 41.

## Description

### FIELD

The present invention relates to an electronic device including a display device.

### BACKGROUND

As a display device, there is known an organic EL display device using an organic electroluminescence element (organic EL element). The organic EL display device is of a self-luminescence type, and has such characteristics as a high contrast, a wide viewing angle and a high response speed.

In the organic EL display device, for example, one of two electrodes, which sandwich an organic light-emission layer, is composed of a metallic electrode which reflects light, and the other electrode is composed of a transparent electrode. By this configuration, light generated by the organic light-emission layer can efficiently be utilized.

On the other hand, when outside light, such as sunlight, is incident on the organic EL display device, the outside light is reflected by the metallic electrode. In order to prevent mirror reflection by the metallic electrode, a polarizer with a λ/4 plate needs to be provided on the transparent electrode side. In this case, since the light generated by the organic light-emission layer passes through the polarizer, the brightness of the organic EL display device lowers.

### SUMMARY

### TECHNICAL PROBLEM

The present invention provides an electronic device which can realize a plurality of display modes, while improving brightness.

### SOLUTION TO PROBLEM

According to an aspect of the present invention, there is provided an electronic device comprising: a first display panel; a second display panel; a spacer configured to keep a distance between the first display panel and the second display panel; and an air layer which is provided between the first display panel and the second display panel and is surrounded by the spacer. The first display panel includes: first and second substrates; a plurality of pixel electrodes which are provided on the first substrate and reflect light; a plurality of light-emission layers which are provided on the pixel electrodes and emit light; and a first common electrode which is provided on the second substrate and is in contact with the light-emission layers. The second display panel includes: third and fourth substrates; a polymer dispersed liquid crystal layer filled between the third substrate and the fourth substrate; a plurality of display electrodes provided on the third substrate; and a second common electrode provided on the fourth substrate. The second substrate of the first display panel is disposed in such a manner as to directly face the second display panel.

### ADVANTAGEOUS EFFECTS

According to the present invention, there can be provided an electronic device which can realize a plurality of display modes, while improving brightness.

### BRIEF DESCRIPTION OF THE DRAWINGS

FIG. 1 is a block diagram of an electronic watch according to a first embodiment of the present invention.
FIG. 2 is a schematic view of the electronic watch.
FIG. 3 is a cross-sectional view of a display unit.
FIG. 4 is a plan view of a plurality of display electrodes which a second display panel includes.
FIG. 5 is a view for illustrating an operation of the display unit in character display.
FIG. 6 is a view for illustrating an operation of the display unit in information display of a first example.
FIG. 7 is a view for illustrating an operation of the display unit in information display of a second example.
FIG. 8 is a view for illustrating an operation of the display unit in information display of a third example.
FIG. 9 is a block diagram of an electronic watch according to a second embodiment of the present invention.
FIG. 10 is a cross-sectional view of a display unit including a touch panel.
FIG. 11 is a flowchart for illustrating an operation of the electronic watch.

### DETAILED DESCRIPTION

A description will now be given of the embodiments with reference to the accompanying drawings. It should be noted that the drawings are schematic or conceptual, and the dimensions and scales of the drawings are not necessarily the same as the actual products. Where the same portion is depicted in different drawings, the dimensions and scale of one drawing may be different from those of another. Several embodiments described below merely show exemplary apparatuses and methods that implement the technical ideas of the present invention. The technical ideas are not limited by the element shapes, structures, arrangements etc. described below. In the description below, structural elements having substantially the same functions and configurations will be denoted by the same reference symbols, and a repetitive description of such elements will be given only where necessary.

In each of the following embodiments, an electronic watch will be described by way of example, as an electronic device including a display device.

### [First Embodiment]

### [1] Configuration of Electronic Watch

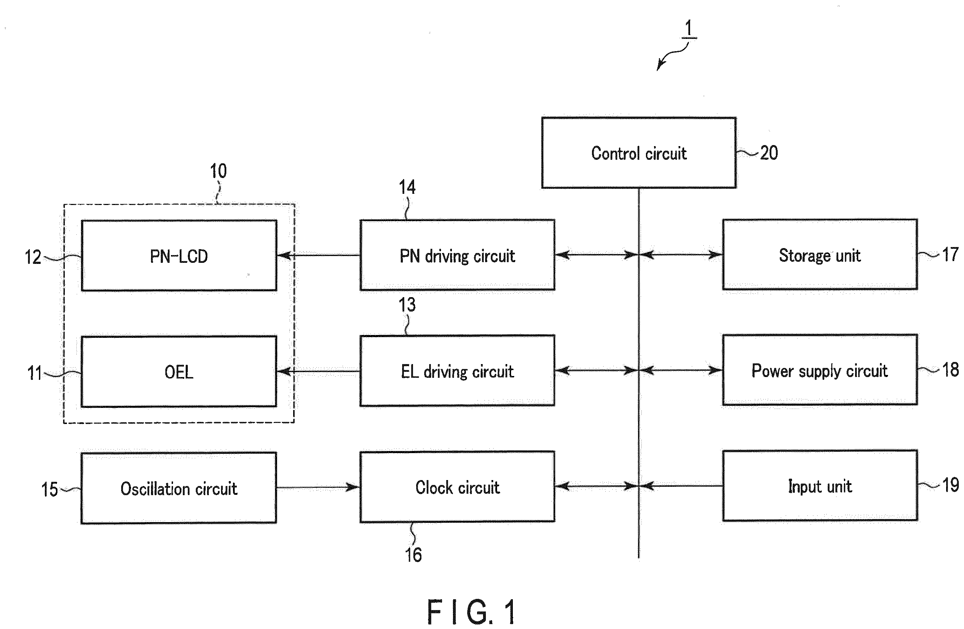

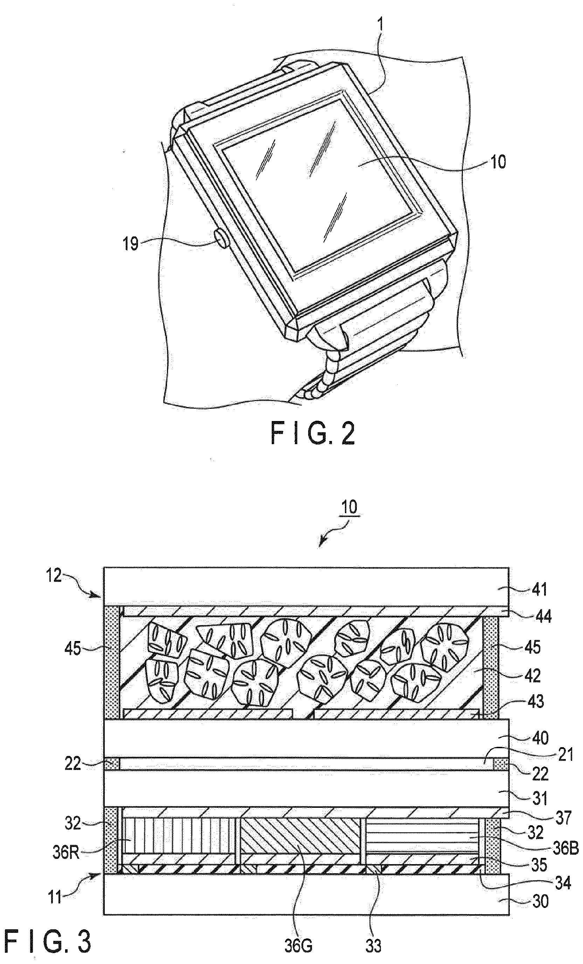

FIG. 1 is a block diagram of an electronic watch 1 according to a first embodiment of the present invention. FIG. 2 is a schematic view of the electronic watch 1. The electronic watch 1 includes a display unit 10, an EL driving circuit 13, a PN driving circuit 14, an oscillation circuit 15, a clock circuit 16, a storage unit 17, a power supply circuit 18, an input unit 19, and a control circuit 20. The display unit 10 includes a first display panel 11 and a second display panel 12.

The first display panel (OEL) 11 is composed of an organic EL display element. The second display panel (PN-LCD) 11 is composed of a polymer dispersed liquid crystal display element. Concrete configurations of the first display panel 11 and second display panel 12 will be described later.

The EL driving circuit 13 is electrically connected to a plurality of signal lines which are connected to the first display panel 11, and drives the first display panel 11. The PN driving circuit 14 is electrically connected to a plurality of signal lines which are connected to the second display panel 12, and drives the second display panel 12.

The oscillation circuit 15 generates a clock signal having a fixed frequency. The clock circuit 16 calculates present time data and the like, by using the clock signal which is input from the oscillation circuit 15. The clock circuit 16 sends the calculated present time data, date data, etc., to the control circuit 20.

The storage unit 17 includes, for example, a ROM (Read Only Memory) for data read, and a RAM (Random Access Memory) which is capable of data read and data write. The RAM is used as a working area of the control circuit 20. The storage unit 17 includes a program area which stores a system program, application programs, and the like for realizing various functions of the electronic watch 1, and a data area which stores various data such as image data.

The power supply circuit 18 supplies various voltages to the respective modules in the electronic watch 1 via power supply lines. The power supply circuit 18 includes, for example, a button battery (primary battery).

The input unit 19 includes a plurality of push buttons for instructing execution of various functions of the electronic watch 1. If the input unit 19 is operated by a user, time setting is performed, or various modes are selected, in response to the operation.

The control circuit 20 controls the entire operation of the electronic watch 1. The control circuit 20 is composed of a CPU (Central Processing Unit), etc. For example, at a predetermined timing, or in response to a signal which is input from the input unit 19, the control circuit 20 reads out various programs stored in the ROM, loads the programs into the working area of the RAM, and executes instructions (controls) to the respective modules that constitute the electronic watch 1, or executes data transfer or the like, in accordance with the programs.

In addition, although depiction is omitted, the electronic watch 1 may include a camera function (imaging unit), a communication function, and the like.

### [1-1] Configuration of Display Unit 10

Next, a configuration of the display unit 10 will be described. FIG. 3 is a cross-sectional view of the display unit 10.

The display unit 10 includes the first display panel 11 and second display panel 12, and the first display panel 11 and second display panel 12 are stacked via a transparent member (e.g. air layer) 21.

The first display panel 11 performs character display with a large information amount or image display (hereinafter referred to as "information display"), and can perform color display. The first display panel 11 is composed of an organic EL display element. Specifically, the first display panel 11 is a self-luminescence-type display element, and can perform image display without using an illumination device (backlight).

The second display panel 12 is of a pattern display type which performs character display with a small information amount and figure display (hereinafter referred to as "character display"), and can perform display of a transparent state and a scattered state, i.e. black-and-white display. The character display includes display of a character with a small information amount or a figure, and time display (segment display). The second display panel 12 is composed of, for example, a liquid crystal display panel selected from between a polymer dispersed liquid crystal (PDLC) and a polymer network liquid crystal (PNLC). Since the second display panel 12 does not use a polarizer, the amount of light absorbed in the second display panel 12 can greatly be reduced, and a bright screen can be obtained. In addition, the second display panel 12 can perform a display operation with low power consumption.

In this manner, in the display unit 10 of the present embodiment, the second display panel 12 performs the character display (including time display and standby display), and the first display panel 11 performs the information display with a greater information amount than the character display.

The first display panel 11 and second display panel 12 are stacked via a transparent member 21. The transparent member 21 is in contact with a lower substrate 40 of the second display panel 12, and the refractive index of the transparent member 21 is set to be different from the refractive index of the lower substrate 40. The transparent member 21 may be a transparent material which meets the above-described condition, and may be a gas. In the present embodiment, the transparent member 21 is composed of, for example, an air layer 21.

The first display panel 11 and second display panel 12 are attached by a spacer (or a seal member) 22. The spacer 22 has a function of holding the first display panel 11 and second display panel 12, with a distance being provided therebetween. The spacer 22 is formed in a rectangular shape, in such a manner as to surround an outer periphery of the second display panel 12 (and first display panel 11). The air layer 21 is provided between the first display panel 11 and second display panel 12, such that the air layer 21 is surrounded by the spacer 22.

By providing the air layer 21 between the first display panel 11 and second display panel 12, incident light on the second display panel 12 from the display surface side is reflected by an interface between the lower substrate 40 and air layer 21. As a result, bright display by the second display panel 12 can be realized, and the contrast of the display unit 10 can be improved. Moreover, by using the air layer 21 as the transparent member 21, the cost of the display unit 10 can be reduced.

### [1-2] Configuration of First Display Panel 11

Next, a configuration of the first display panel 11 will be described. The first display panel 11 adopts an active matrix driving method in which active elements are disposed in association with respective pixels.

The first display panel 11 includes a TFT substrate 30 on which a TFT (Thin Film Transistor) functioning as an active element (switching element), a pixel electrode, etc. are formed; an opposite substrate 31 on which a common electrode is formed and which is disposed to be opposed to the TFT substrate 30; and a light-emission layer provided between the TFT substrate 30 and opposite substrate 31. The TFT substrate 30 and opposite substrate 31 are attached by a seal member 32. The light-emission layer is sealed between the TFT substrate 30 and opposite substrate 31 by the seal member 32. Each of the TFT substrate 30 and opposite substrate 31 is composed of a transparent substrate (e.g. a glass substrate or a plastic substrate).

On the TFT substrate 30, a switching element (TFT) 33 and a pixel electrode 35 are provided in association with each of pixels. In FIG. 3, the TFT 33 is illustrated in a simplified manner. The TFT 33 includes a gate electrode which is electrically connected to a scanning line; a gate insulating film provided on the gate electrode; a semiconductor layer provided on the gate insulating film; and a source electrode and a drain electrode which are provided on the semiconductor layer and spaced apart from each other. The source electrode is electrically connected to a signal line.

The pixel electrode 35 is electrically connected to the drain electrode of the TFT 33. The pixel electrode 35 is composed of a metal which can reflect light. The pixel electrode 35 reflects light, which is generated by the light-emission layer, toward the opposite substrate 31. An insulating layer 34, which is provided between the pixel electrode 35 and TFT substrate 30, is illustrated by depicting, in a simplified manner, an insulating material (including a gate insulating film) which is necessary for stacking the electrodes included in the TFT 33.

A plurality of light-emission layers 36 are provided on a plurality of pixel electrodes 35, respectively. The light-emission layers 36 include a red light-emission layer 36R which emits red light, a green light-emission layer 36G which emits green light, and a blue light-emission layer 36B which emits blue light. In FIG. 3, for the purpose of simplicity, three light-emission layers 36R, 36G and 36B are illustrated by way of example. Actually, sets of light-emission layers 36R, 36G and 36B are arranged, for example, in a matrix.

The red light-emission layer 36R, green light-emission layer 36G and blue light-emission layer 36B can be composed by using a well-known material. Each light-emission layer (organic layer) 36 may be composed of three layers, i.e. a hole transport layer, a light-emitting layer, and an electron transport layer. The hole transport layer has a function of transporting holes, which are injected from an interface with a lower electrode, to the light-emitting layer. The electron transport layer has a function of transporting electrons, which are injected from an interface with an upper electrode, to the light-emitting layer. The light-emitting layer has a function of emitting light by recombining the hole transported from the hole transport layer and the electron transported from the electron transport layer. In addition, the organic layer 36 may employ a 5-layer structure, or the like. Specifically, the hole transport layer may be functionally divided into a hole injection layer and a hole transport layer in the order from the lower electrode side, and may be composed of these two layers. Similarly, the electron transport layer may be functionally divided into an electron injection layer and an electron transport layer in the order from the upper electrode side, and may be composed of these two layers.

A common electrode 37 is provided on the opposite substrate 31. The common electrode 37 is formed in a planar shape over the entire display area. In the example of FIG. 3, the common electrode 37 is led out to the outside of the seal member 32. The common electrode 37 is composed of a transparent electrode, and ITO (indium-tin-oxide), for instance, is used. The common electrode 37 is in contact with the light-emission layers 36. The opposite substrate 31 and common electrode 37 seal the light-emission layer 36.

The opposite substrate 31 is disposed in a manner to directly face the second display panel 12. The opposite substrate 31 is in contact with the air layer 21. The first display panel 11 may include an optical member for improving display characteristics, on that surface of the opposite substrate 31, which is opposite to the common electrode 37. In this case, this optical member is in contact with the air layer 21.

### [1-3] Configuration of Second Display Panel 12

Next, a configuration of the second display panel 12 will be described.

The second display panel 12 includes the lower substrate 40 on which a display electrode is formed; an upper substrate 41 on which a common electrode is formed and which is disposed to be opposed to the lower substrate 40; and a liquid crystal layer 42 interposed between the lower substrate 40 and upper substrate 41. That surface of the upper substrate 41, which is opposite to the liquid crystal layer 42, is a display surface of the display unit 10. Each of the lower substrate 40 and upper substrate 41 is composed of a transparent substrate (e.g. a glass substrate or a plastic substrate).

A plurality of display electrodes 43 are provided on the lower substrate 40. In FIG. 3, for the purpose of simplicity, two display electrodes 43 are depicted by way of example. The display electrodes 43 are processed in a shape corresponding to a character which the second display panel 12 can display. A common electrode 44 is provided on the upper substrate 41. The common electrode 44 is formed in a planar shape over the entire display area, and is provided in a manner to cover all display electrodes 43. In the example of FIG. 3, the common electrode 44 is led out to the outside of a seal member 45. Each of the display electrodes 43 and common electrode 44 is composed of a transparent electrode, and ITO, for instance, is used. For example, a UV (ultraviolet) cut film (not illustrated) is provided on the display surface side of the upper substrate 41.

The liquid crystal layer 42 is sealed by the seal member 45 which attaches the lower substrate 40 and upper substrate 41. As described above, the liquid crystal layer 42 is composed of, for example, a polymer dispersed liquid crystal (PDLC) or a polymer network liquid crystal (PNLC). The PNLC has such a structure that a liquid crystal material is dispersed in a polymer network, and the liquid crystal material in the polymer network has a continuous phase. The PDLC has such a structure that a liquid crystal is dispersed by a polymer, i.e. a liquid crystal is phase-separated in a polymer. A photo-curing resin can be used as a polymer-molecule layer (polymer layer). For example, in the PNLC, ultraviolet is radiated on a solution in which a liquid crystal material is mixed in a photopolymerizable polymer-precursor (monomers), and the monomers are polymerized to form a polymer, and a liquid crystal material is dispersed in the network of the polymer.

A positive-type (P-type) nematic liquid crystal is used as the liquid crystal material of the liquid crystal layer 42. Specifically, the major axes (director) of liquid crystal molecules are aligned at random at a time of no voltage (no electric field), and the director of liquid crystal molecules is aligned substantially perpendicular to the substrate surface when voltage is applied (electric field is applied).

The lower substrate 40 is in contact with the air layer 21. The second display panel 12 may include an optical member for improving display characteristics, on that surface of the lower substrate 40, which is opposite to the liquid crystal layer 42. In this case, this optical member is in contact with the air layer 21.

Note that the positional relationship between the common electrode and display electrode may be reversed. Specifically, the common electrode may be formed on the lower substrate 40, and the display electrode may be formed on the upper substrate 41.

### [1-4] Configuration of Display Electrode 43

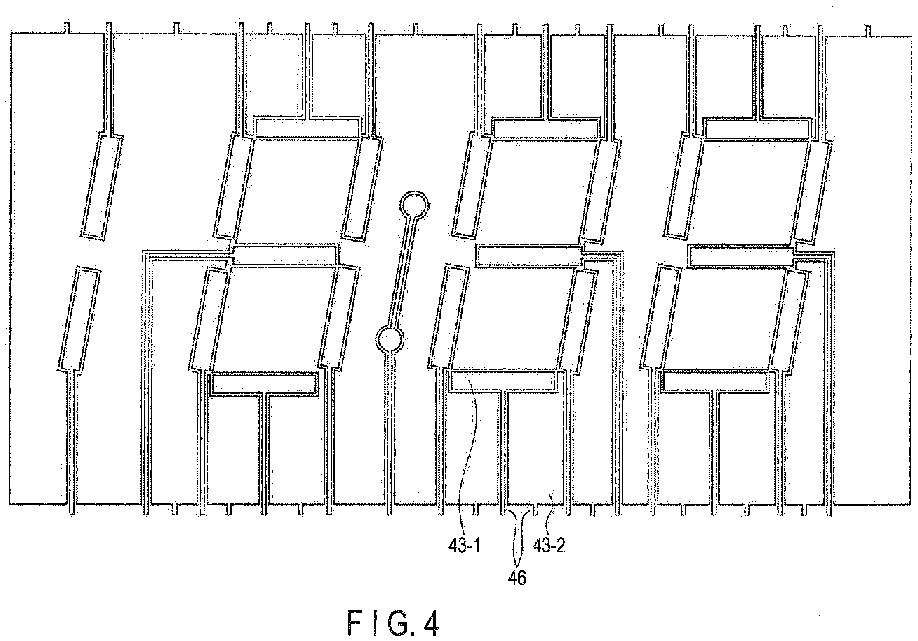

Next, a description is given of an example of the configuration of the display electrodes 43 which the second display panel 12 includes. FIG. 4 is a plan view of the display electrodes 43 which the second display panel 12 includes. FIG. 4 illustrates a configuration example of the display electrodes 43 for displaying time.

The display electrodes 43 include a plurality of display electrodes 43-1 which are processed in a shape of a character, and a plurality of display electrodes 43-2 which are disposed in a manner to fill gaps between the display electrodes 43-1. In addition, the display electrodes 43-1 and display electrodes 43-2 are formed in a manner to cover the entire display area. The display electrodes 43-1 and display electrodes 43-2 are electrically isolated from each other. The display electrodes 43-1 and display electrodes 43-2 are disposed with a distance corresponding to a minimum processing size due to a manufacturing process.

A plurality of lead electrodes 46 are electrically connected to the display electrodes 43-1 and display electrodes 43-2, respectively. Each of the lead electrodes 46 extends in one direction and is led out to the outside of the display area.

In the display electrodes 43 with the above configuration, voltage may be applied to a character part, or a voltage may be applied to the entire display area.

### [2] Operation of Electronic Watch 1

An operation of the electronic watch 1 with the above-described configuration will be described. The operation of the display unit 10 (first display panel 11 and second display panel 12) is controlled by the EL driving circuit 13, PN driving circuit 14 and control circuit 20.

### [2-1] Character Display

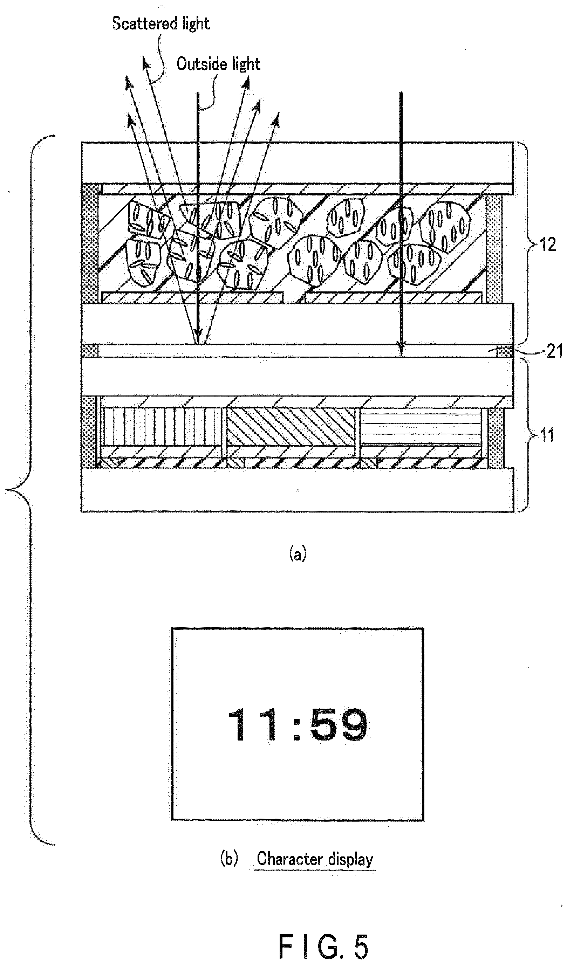

To begin with, an operation of character display will be described. FIG. 5 is a view for illustrating the operation of the display unit 10 in the character display. Part (a) of FIG. 5 is a cross-sectional view, and part (b) of FIG. 5 illustrates an image which is displayed on the display area of the display unit 10.

In the character display, the second display panel 12 performs a display operation, and the first display panel 11 is in the OFF state. Outside light is incident on the second display panel 12 from the upper substrate 41 side. In the outdoors, a main component of outside light is sunlight. The second display panel 12 does not require a backlight, and performs a display operation by using outside light.

In the liquid crystal layer 42 of the second display panel 12, a liquid crystal is dispersed in the polymer network, and the alignment of liquid crystal molecules is random when no voltage (no electric field) is applied. If the refractive index of extraordinary light of liquid crystal molecules is ne, and the refractive index of ordinary light is no, "ne > no". If the refractive index of the polymer network is n, "n = no" is set. If outside light is incident on an OFF-state area of the second display panel 12 from the display surface side, light is scattered and white display is effected since the alignment of liquid crystal molecules is random. At this time, since the air layer 21, whose refractive index is different from the refractive index of the lower substrate 40, is present under the lower substrate 40, the light reaching the lower substrate 40 is reflected by the interface between the lower substrate 40 and air layer 21. As a result, bright display by the second display panel 12 can be realized.

On the other hand, when voltage (electric field) is applied to the liquid crystal layer 42 (ON state), the major axes (director) of liquid crystal molecules are aligned in the direction of the electric field, and the refractive index of the liquid crystal layer 42 becomes a uniform value n. Outside light, which is incident on an ON-state area of the second display panel 12 from the display surface side, passes through the liquid crystal layer 42 and travels straight. In this case, the light, which has passed through the liquid crystal layer 42, reaches the opposite substrate 31 of the first display panel 11, but is not reflected there, and thus black display is effected.

In part (a) of FIG. 5, a left half of the liquid crystal layer 42 represents a scattered state (white display), and a right half of the liquid crystal layer 42 represents a transmissive state (black display).

The PN driving circuit 14 applies a positive voltage to the display electrodes 43-1 which are processed in the shape of a character, and applies 0 V to the common electrode 44. In addition, the PN driving circuit 14 applies 0 V to the display electrodes 43-2 which are formed around the character, and applies 0 V to the common electrode 44. The display electrode 43 and common electrode 44 are AC-driven, and the polarities of their voltages are reversed in every half cycle. In the description below, the liquid crystal layer is AC-driven, even in cases not particularly mentioned.

White display is effected in the area where the display electrode 43 is in the OFF state, and black display is effected in the area where the display electrode 43 is in the ON state. Thereby, freely selected character display (in the present embodiment, time display, standby display and the like) can be realized.

### [2-2] Information Display

Next, an operation of information display will be described. In the information display, the first display panel 11 performs a display operation, and the entire area of the second display panel 12 is switched to one of a plurality of states between a transmissive state and a scattered state.

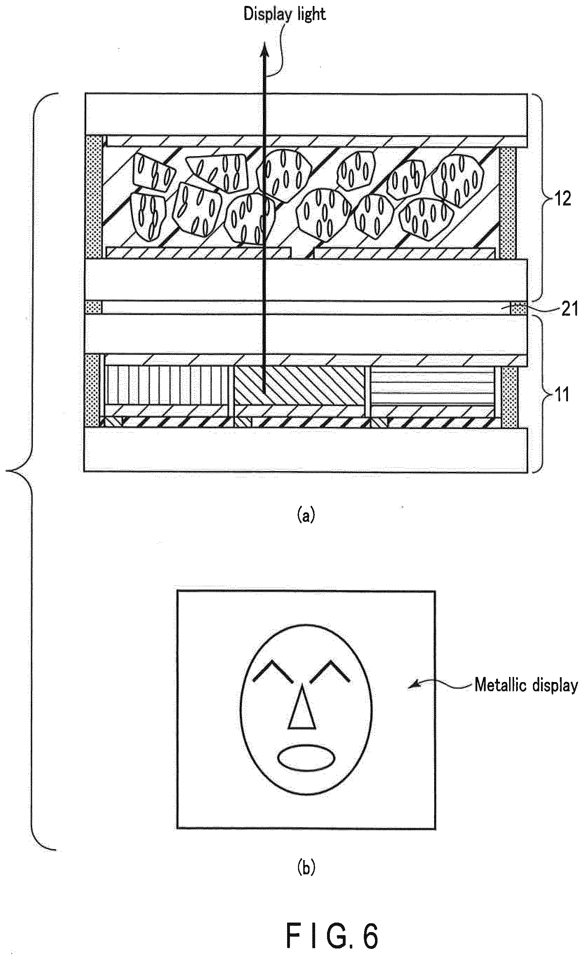

FIG. 6 is a view for illustrating the operation of the display unit 10 in information display of a first example. The EL driving circuit 13 causes the first display panel 11 to display a color image. Specifically, the EL driving circuit 13 applies a positive voltage to the pixel electrode 35, and applies 0 V to the common electrode 37.

In the first example, the entire area of the second display panel 12 is set in the transmissive state (ON state). Specifically, the PN driving circuit 14 applies a positive voltage to all display electrodes 43, and applies 0 V to the common electrode 44. The positive voltage in the transmissive state is a threshold voltage or more of the liquid crystal, and the liquid crystal molecules are aligned in a substantially vertical direction. The gradation in the transmissive state is called "full gradation".

Here, the pixel electrode 35 of the first display panel 11 is composed of a reflective metal. In addition, neither a λ/4 plate nor a polarizer is present between the pixel electrode 35 and second display panel 12. Thus, since the user (observer) visually recognizes the reflective metal of the first display panel 11, the entirely of the display image of the display unit 10 becomes metallic display. The metallic display is display with a metallic gloss.

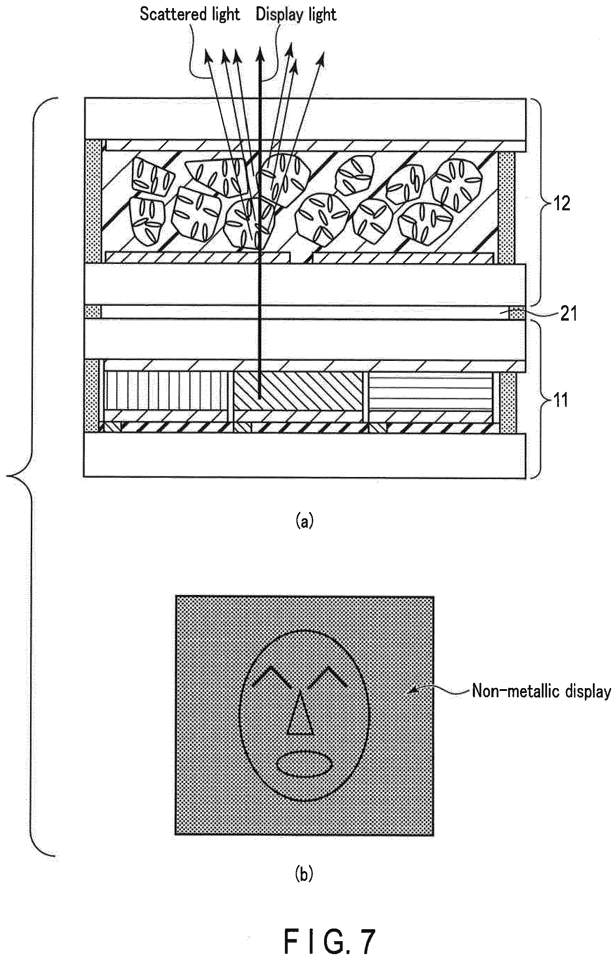

FIG. 7 is a view for illustrating the operation of the display unit 10 in information display of a second example. In the second example, too, the EL driving circuit 13 causes the first display panel 11 to display a color image.

In the second example, the entire area of the second display panel 12 is set in the scattered state (OFF state). Specifically, the PN driving circuit 14 applies 0 V to all display electrodes 43 and the common electrode 44. The gradation in the scattered state is called "zero gradation".

The light emitted from the first display panel 11 is scattered by the second display panel 12. In the second example, since the user can hardly visually recognize the reflective metal of the first display panel 11, the entirely of the display image of the display unit 10 becomes non-metallic display.

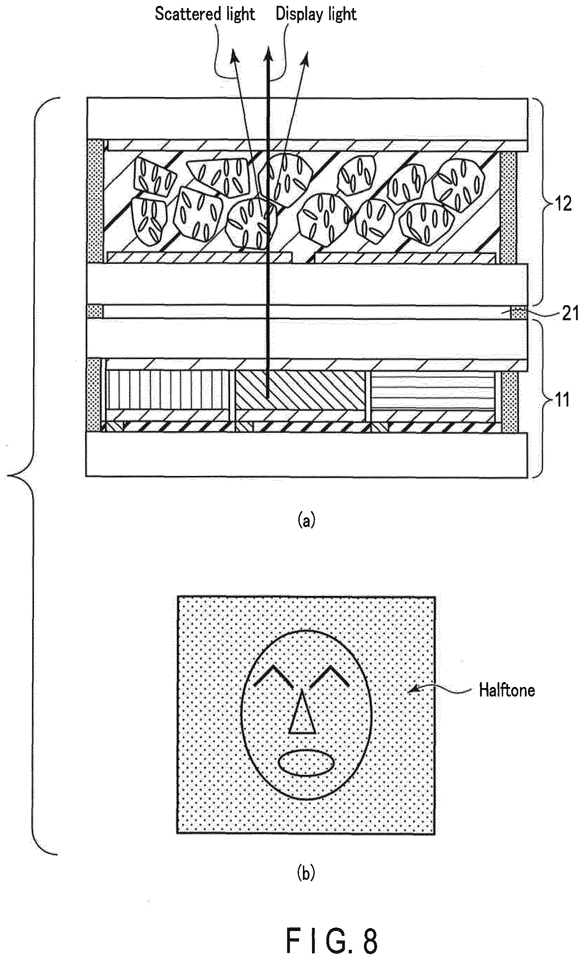

FIG. 8 is a view for illustrating the operation of the display unit 10 in information display of a third example. In the third example, too, the EL driving circuit 13 causes the first display panel 11 to display a color image.

In the third example, the entire area of the second display panel 12 is set in halftone. The halftone represents a state between the full gradation (transmissive state) and the zero gradation (scattered state). In the halftone, the PN driving circuit 14 applies an intermediate voltage, which is lower than the positive voltage at the time of the full gradation and is higher than 0 V, to all display electrodes 43, and applies 0 V to the common electrode 44. In the halftone, the liquid crystal molecules are obliquely aligned as a whole.

The light emitted from the first display panel 11 is weakly scattered by the second display panel 12. In the third example, since the user slightly visually recognizes the reflective metal of the first display panel 11, the entirely of the display image of the display unit 10 becomes generally weak metallic display.

Note that the degree of metallic display can freely be set by varying the voltage level at the time of the halftone.

### [3] Advantageous Effects of the First Embodiment

As has been described above in detail, in the first embodiment, the electronic watch (electronic device) 1 includes the first display panel 11 composed of the organic EL display element; the second display panel 12 composed of the polymer dispersed liquid crystal element; the spacer 22 configured to keep the distance between the first display panel 11 and second display panel 12; and the air layer 21 which is provided between the first display panel 11 and second display panel 12 and is surrounded by the spacer 22. The first display panel includes the pixel electrodes 35 which are provided on the TFT substrate 30 and reflect light; the light-emission layers 36 which are provided on the pixel electrodes 35 and emit light; and the common electrode 37 which is provided on the opposite substrate 31 and is in contact with the light-emission layers 36. The second display panel 12 includes the polymer dispersed liquid crystal layer 42 filled between the lower substrate 40 and upper substrate 41; the display electrodes 43 provided on the lower substrate 40; and the common electrode 44 provided on the upper substrate 41. In addition, the opposite substrate 31 of the first display panel 11 is disposed in such a manner as to directly face the second display panel 12.

Thus, according to the first embodiment, since the first display panel 11 uses neither a retardation plate (λ/4 plate) nor a polarizer, the light emitted from the light-emission layer 36 is not partially absorbed by the polarizer. Thereby, the brightness of the display unit 10 can be enhanced. Similarly, the second display panel 12 does not require a polarizer. Thereby, the brightness of the display unit 10 can be enhanced.

In addition, by turning off the first display panel 11, the second display panel 12 can perform the character display by using outside light. Thereby, the power consumption of the electronic watch 1 can be reduced.

Furthermore, the first display panel 11 performs the information display, and the second display panel 12 can be set in the full-area transmissive state. At this time, the metallic display can be effected by the reflective metal which the first display panel 11 includes.

Besides, halftone between the metallic display and non-metallic display can be displayed by varying the level of the transmissive state, that is, the gradation, of the second display panel 12. In this manner, the electronic watch 1 according to the present embodiment can realize a plurality of kinds of display modes.

### [Second Embodiment]

In a second embodiment, the display mode of the electronic watch 1 can be switched, based on an operation of a touch sensor by a user.

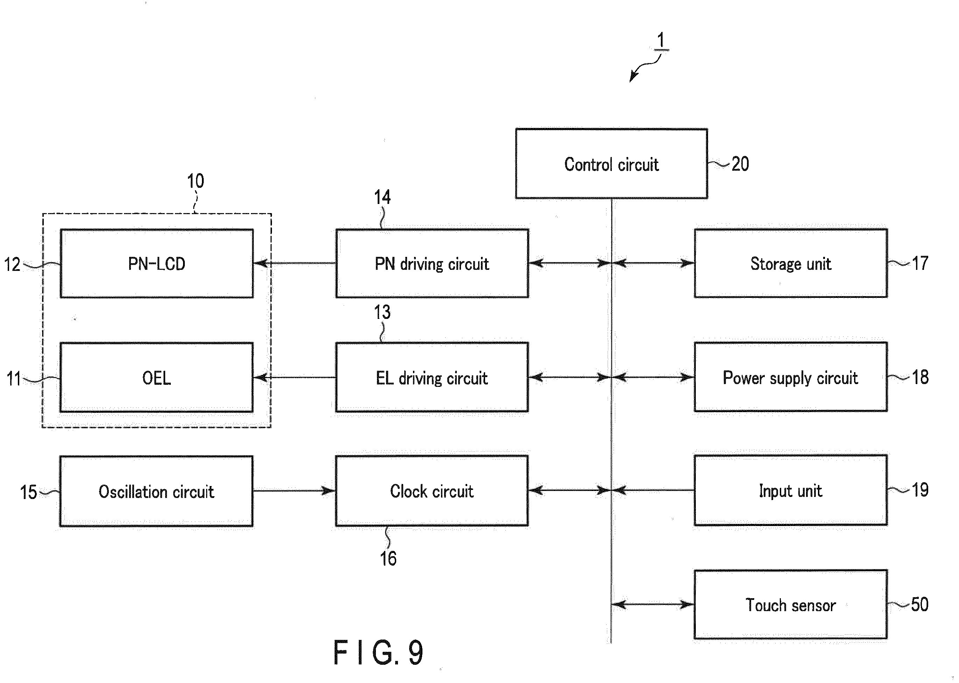

FIG. 9 is a block diagram of an electronic watch 1 according to the second embodiment of the present invention. The electronic watch 1 further includes a touch sensor 50.

The touch sensor 50 detects that the user has pressed the screen of the electronic watch 1, and further specifies a pressed position, i.e. the coordinates of a tap position. The detection method of the touch sensor 50 may be any one of a resistive film type, an electrostatic capacitance type, an electromagnetic induction method, a surface acoustic wave type, an infrared scanning method, and the like. The touch sensor 50 includes a touch panel 51.

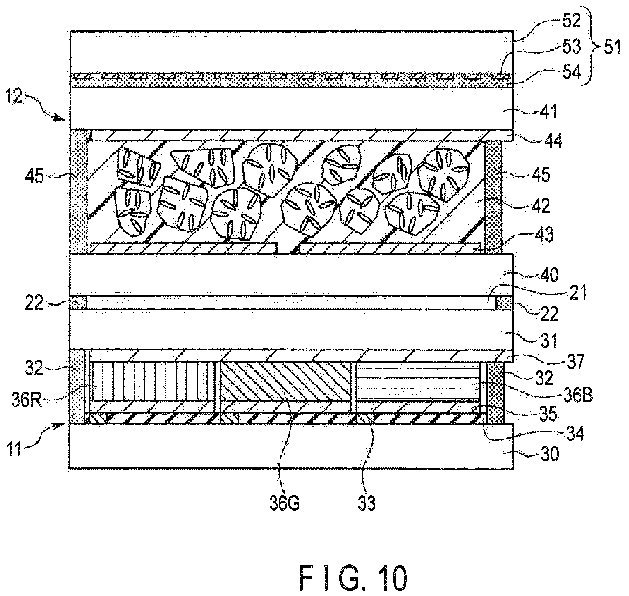

FIG. 10 is a cross-sectional view of the display unit 10 including the touch panel 51. FIG. 10 illustrates a configuration example of the touch panel 51 which adopts an electrostatic capacitance type.

The touch panel 51 is provided on the display surface side of the second display panel 12. The touch panel 51 includes a transparent substrate (e.g. a glass substrate) 52. A plurality of transparent electrodes 53 having a desired sensor pattern are provided on the transparent substrate 52. The transparent substrate 52 and transparent electrodes 53 are attached to the second display panel 12 by using a transparent adhesive 54.

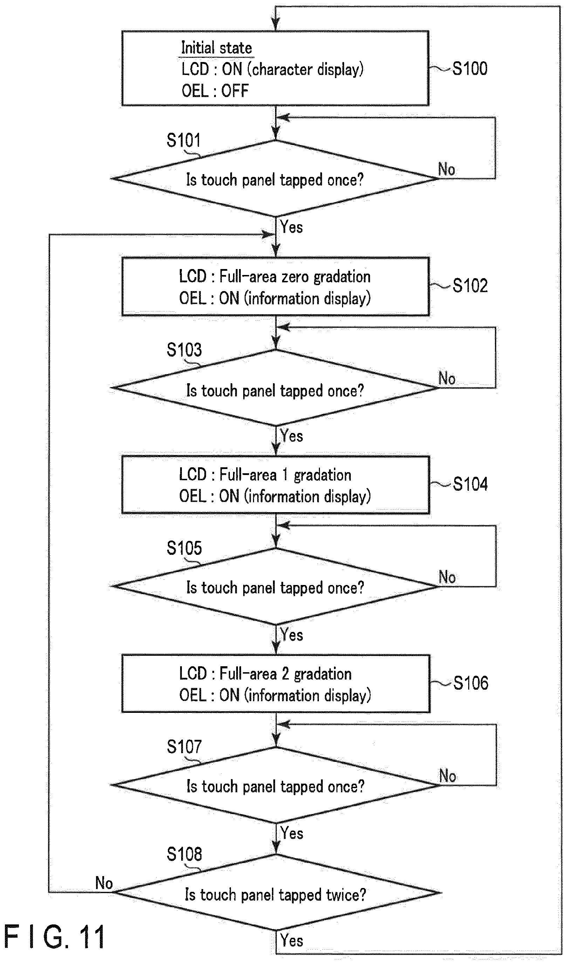

Next, an operation of the electronic watch 1 with the above-described configuration will be described. FIG. 11 is a flowchart for illustrating the operation of the electronic watch 1.

In an initial state, for example, the electronic watch 1 performs character display (step S100). Specifically, the PN driving circuit 14 causes the second display panel (LCD) 12 to perform character display. The EL driving circuit 13 turns off the first display panel (OEL) 11.

Subsequently, the touch sensor 50 monitors whether the touch panel 51 was tapped once (step S101). In step S101, if the touch panel 51 was tapped once, the electronic watch 1 performs information display and non-metallic display (step S102). Specifically, the PN driving circuit 14 sets the second display panel 12 to a full-area zero gradation. Thereby, the second display panel 12 is set in a full-area scattered state. The EL driving circuit 13 causes the first display panel 11 to perform information display.

Then, the touch sensor 50 monitors whether the touch panel 51 was tapped once again (step S103). In step S103, if the touch panel 51 was tapped once again, the electronic watch 1 performs information display and halftone (1 gradation) display (step S104). Specifically, the PN driving circuit 14 sets the second display panel 12 to a full-area 1-gradation. Thereby, the entire area of the second display panel 12 is set in a slightly scattered state. The EL driving circuit 13 causes the first display panel 11 to perform information display.

Subsequently, the touch sensor 50 monitors whether the touch panel 51 was tapped once again (step S105). In step S105, if the touch panel 51 was tapped once again, the electronic watch 1 performs information display and metallic display (step S106). For example, it is assumed that a 2-gradation is a full gradation. The PN driving circuit 14 sets the second display panel 12 to a full-area 2-gradation. Thereby, the second display panel 12 is set in a full-area transmissive state. The EL driving circuit 13 causes the first display panel 11 to perform information display.

Note that two or more levels of the halftone may be provided. The switching of the level of the halftone is also performed by the touch panel 51.

Following the above, the touch sensor 50 monitors whether the touch panel 51 was tapped once again (step S107). Subsequently, the touch sensor 50 monitors whether the touch panel 51 was further tapped once again (i.e. whether the touch panel 51 was successively tapped twice) (step S108).

If the touch panel 51 was tapped once (step S108 = No), the control circuit 20 returns to step S102. On the other hand, if the touch panel 51 was successively tapped twice (step S108 = Yes), the control circuit 20 returns to step S100.

As has been described above in detail, according to the second embodiment, one of the display modes can be selected and executed in accordance with the operation by the user.

Note that, in each of the above-described embodiments, the three-color light-emission method was described by way of example as the organic EL display element, but other light-emission methods may be used. For example, a color conversion method or a color filter method may be used. The color conversion method is a method in which an organic EL element that emits blue light is used and the blue light is converted to green light or red light by a fluorescence conversion layer. The color filter method is a method in which an organic EL element that emits white light is used and the white light is converted to RGB by filtering the white light by color filters.

Besides, the display units according to the above-described embodiments are applicable to various electronic devices other than the electronic watch.

The present invention is not limited to the above-mentioned embodiments, and can be reduced to practice by modifying the constituent elements without departing from the spirit and scope of the invention. In addition, the above-described embodiments include inventions of various stages, and a variety of inventions can be derived by properly combining structural elements of one embodiment or by properly combining structural elements of different embodiments. For example, if the object of the invention is achieved and the advantages of the invention are attained even after some of the structural elements disclosed in connection with the embodiments are deleted, the structure made up of the resultant structural elements can be extracted as an invention.

## Claims

1. An electronic device comprising:
a first display panel;
a second display panel;
a spacer configured to keep a distance between the first display panel and the second display panel; and
an air layer which is provided between the first display panel and the second display panel and is surrounded by the spacer,
wherein
the first display panel includes:
first and second substrates;
a plurality of pixel electrodes which are provided on the first substrate and reflect light;
a plurality of light-emission layers which are provided on the pixel electrodes and emit light; and
a first common electrode which is provided on the second substrate and is in contact with the light-emission layers,
the second display panel includes:
third and fourth substrates;
a polymer dispersed liquid crystal layer filled between the third substrate and the fourth substrate;
a plurality of display electrodes provided on the third substrate; and
a second common electrode provided on the fourth substrate, and
the second substrate of the first display panel is disposed in such a manner as to directly face the second display panel.

2. The electronic device of Claim 1, further comprising a control circuit configured to control operations of the first and second display panels, and to execute first and second display modes,
wherein
in the first display mode, the first display panel is turned off and the second display panel is set in a display state,
in the second display mode, the first display panel is set in a display state and the second display panel is set in a transmissive state, and
the second display mode is metallic display.

3. The electronic device of Claim 2, wherein
the control circuit is configured to further execute a third display mode, and
in the third display mode, the first display panel is set in the display state and the second display panel is set in a scattered state.

4. The electronic device of Claim 3, wherein
the control circuit is configured to further execute a fourth display mode, and
in the fourth display mode, the first display panel is set in the display state and the second display panel is set to halftone between the transmissive state and the scattered state.

5. The electronic device of Claim 2, further comprising a touch sensor configured to detect a tap operation of a screen,
wherein the control circuit is configured to switch the display mode in accordance with an output of the touch sensor.

6. The electronic device of Claim 1, wherein the light-emission layers include a first light-emission layer configured to emit red light, a second light-emission layer configured to emit green light, and a third light-emission layer configured to emit blue light.

7. The electronic device of Claim 1, wherein
the first display panel is configured to perform black-and-white display, and
the second display panel is configured to perform color display.

8. The electronic device of Claim 1, wherein
the first display panel is configured to perform information display, and
the second display panel is configured to perform character display.
